Europäisches Patentamt

European Patent Office

Office européen des brevets

(11) Publication number: **0 243 709 B1**

# EUROPEAN PATENT SPECIFICATION

(45) Date of publication of patent specification: 26.06.91　(51) Int. Cl.⁵: **H05K 3/44**

(21) Application number: 87104808.8

(22) Date of filing: 01.04.87

(54) A Method of forming a substrate for printed circuitry.

(30) Priority: 01.05.86 US 857870

(43) Date of publication of application:
04.11.87 Bulletin 87/45

(45) Publication of the grant of the patent:
26.06.91 Bulletin 91/26

(84) Designated Contracting States:
DE FR GB IT

(56) References cited:
EP-A- 0 153 098
EP-A- 0 181 416
DE-A- 3 501 372
GB-A- 2 122 650
US-A- 3 936 575

(73) Proprietor: **International Business Machines
Corporation
Old Orchard Road
Armonk, N.Y. 10504(US)**

(72) Inventor: **Mahmoud, Issa Said
10500 Settlers Trail
Austin, TX 78750(US)**
Inventor: **Schrottke, Gustav
11101 Spicewood Parkway
Austin, TX 78750(US)**

(74) Representative: **Bailey, Geoffrey Alan
IBM United Kingdom Limited Intellectual
Property Department Hursley Park
Winchester Hampshire SO21 2JN(GB)**

## Description

The present invention relates to a method of forming a substrate for printed circuitry.

A process for producing aluminium coated sheet steel is described in GB 2 122 650 A. In DE 3501 372 A1 a substrate consisting of an iron/nickel layer, plated on both sides with aluminium foil, is disclosed.

The invention seeks to provide a method of forming a substrate for printed circuitry to which surface-mountable components may be attached.

A method of forming a substrate for printed circuitry comprises, according to the invention, the successive steps of surface treating a layer of an alloy having a coefficient of thermal expansion of less than $6 \times 10^{-6}$ per $°C$ at operating temperatures, and two or more layers of aluminium to have rough surfaces free of contaminates, forming a laminate consisting of said alloy layer sandwiched between said aluminium layers, heat treating the laminate to cause aluminium to diffuse into the alloy layer and annealing the laminate.

How the invention can be carried out will now be described by way of example, with reference to the accompanying drawings, in which:-

Fig. 1 is a block diagram of a process for forming a substrate for printed circuitry;

Fig. 2 represents a cross-section of a substrate produced by the process of Fig. 1;

Fig. 3 illustrates successive steps in one method of mounting components to a substrate made by the process of Fig. 1; and

Fig. 4 shows successive steps in another method for mounting components to a substrate made by the process of Fig. 1.

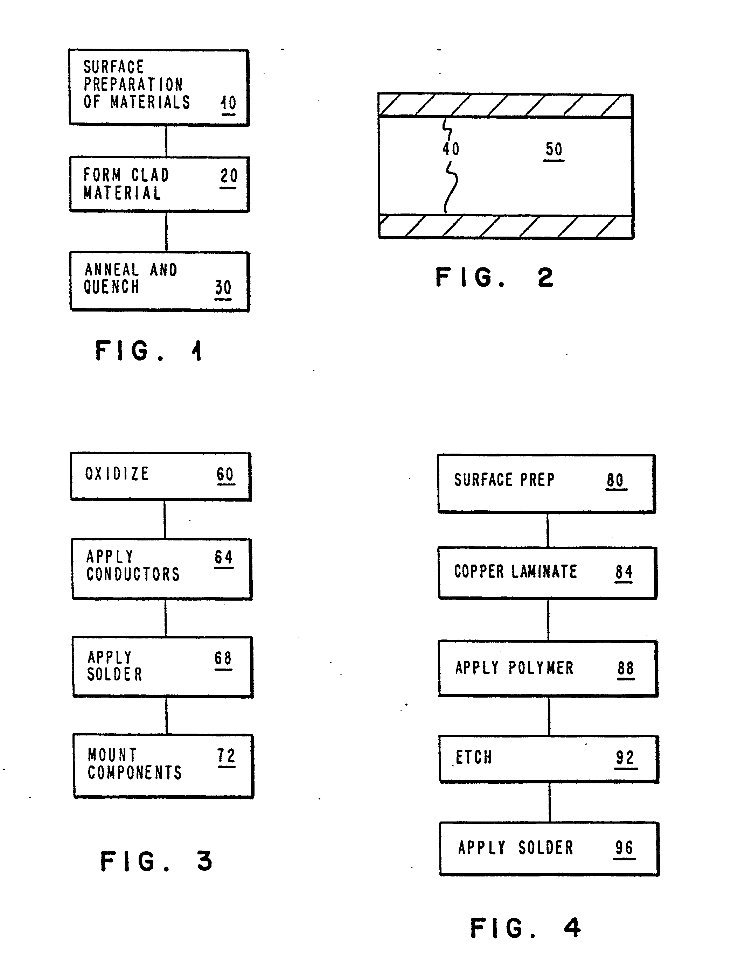

Fig. 1 schematically illustrates a process embodying the invention wherein a strip or sheet of an alloy such as Alloy 42 is clad with strips or sheets of aluminium. Alloy 42 is an alloy consisting of 42% nickel and 58% iron. All the materials must be surface treated as represented by process step 10. A sandwich of the alloy 42 between aluminium is hot rolled to form a laminate as represented by process block 20. The resulting laminate is annealed as represented by process block 30.

The object of the surface preparation step 10 is to have rough surfaces free of oxides, oil, dirt or any other contaminates. Conventional techniques may be used as discussed in metal finishing handbooks such as Heat Treating, Cleaning and Finishing Metals, American Metals Society 8th Edition, 1974, section on Cleaning and Finishing NonFerrous Metals which lists several chemical and/or mechanical treatments. A preferred treatment includes sand blasting the surfaces of both materials which are then cleaned in a caustic solution having a pH preferably in the range of 10 to 12 for three to five minutes at a temperature of 60 to 71$°C$ (140 to 160$°F$). The materials are treated in a deoxidizing solution, preferably of sulfuric and nitric acids which is about 5% by volume nitric acid and 10% by volume sulfuric acid, the balance by volume of water. A water rinse step which may be preferably carried out in a three stage apparatus next follows. Lastly, the materials may be allowed to air dry.

Refer now to Fig. 2 which illustrates the laminate formed at step 20 in Fig. 1 by hot rolling the sandwich structure of three strips or sheets, two 40 of aluminium sandwiching one 50 of an alloy having a low thermal coefficient of expansion therebetween. The hot rolling step is used to laminate the aluminium to the alloy and preferably takes place in a reducing atmosphere utilising stainless steel rollers heated to a temperature in the range of about 315 to 473$°C$ (600 to 900$°F$). Rolling pressure is chosen as a function of the yield strength of the aluminium used. In this preferred embodiment Alloy 1100 (99.5% Al, 0.2% Si, 0.2 % Fe and traces of Ti and Mg) was used and it required about $2.07 \times 10^7$ Pa (3 kilopounds per square inch) pressure. The annealing step 30, Fig. 1, preferably occurs at a temperature in the range of about 260 to 371$°C$ (500 to 700$°F$) for one to five minutes. The resultant laminate is then cooled in air at room temperature.

Referring again to Fig. 2 the resultant laminate is shown in cross-section wherein the alloy layer 50 is about 500 to 750 micrometers thick and the aluminium layers 40 about 125 to 250 micrometers thick.

When the laminate shown in Fig. 2 is used for printed circuitry the core material 50 of the laminate provides a thermal match between electronic packages and the substrate. The aluminium layers 40 aid in the control of thermal management problems when the laminate is used as a substrate for printed circuitry.

The advantages of using such a substrate for printed circuitry include the ability to control thermal expansion as well as providing for higher thermal conduction. This property enhances the reliability of surface mounted components due to a significant reduction in thermal stresses imparted thereto. There is no alpha particle emission so that the reliability of memory devices mounted on this substrate is improved. The manufacturing steps for producing the substrate are simple. Additionally, built in heat sink and ground plane capability exists.

The process of the present invention preferably contemplates using strips of varying width of the low expansion alloy 50 to which aluminium layers 40 having a thickness of 125 to 250 micrometers are laminated by hot rolling. To make laminated substrate bodies requires the use of sheets of core material alloy and sheets, rather than strips, of aluminium to complete the composite structure. Both strips and sheets have been successfully used depending on the desired size of the resultant substrate. The subsequent heat treatment step allows diffusion of the aluminium into the low expansion alloy. The aluminium surfaces may be converted to alumina using techniques such as an electrolytic process or electric discharge in an oxygen atmosphere.

Using the resultant structure for printed circuitry substrates is advantageous because the thermal coefficient of expansion of aluminium Alloy 42 and silicon are rather close. At operating temperatures the coefficient for silicon is between 2.3 and 3 $\times$ $10^{-6}$ per $^\circ$C. For aluminium Alloy 42 the value is about 4 to 6 $\times$ $10^{-6}$ per $^\circ$C.

The material shown in Fig. 2 produced by the process represented in Fig. 1 may be subjected to different circuit-forming operations. For use of hybrid applications, four steps illustrated in Fig. 3 are used to form circuits on a substrate made in accordance with the process illustrated in Fig. 1. The process steps illustrated in Fig. 3 are conventional in nature. Block 60 represents the need for oxidizing the aluminium layer 40 in the composite structure to form a dielectric layer of aluminium oxide. To this layer conductive material is applied, for example, by screening. This step is represented at block 64. Next, solder and/or adhesive may be applied using conventional techniques. This operation is represented at block 68. Finally, at block 72 components are mounted.

Fig. 4 illustrates a method used when flexible circuits and polymer applications are desired. Process block 80 represents the need for surface preparation of the laminate illustrated in Fig. 2. Next, copper is laminated to at least one surface as represented at block 84. A polymer layer is applied, block 88, over the copper. An etching step follows as shown at block 92 to create the conductive lines on the substrate. Solder is applied as by screening at block 96 and components are again mounted using conventional techniques.

## Claims

1. A method of forming a substrate for printed circuitry, comprising the successive steps of surface treating a layer of an alloy having a coefficient of thermal expansion of less than 6 $\times$ $10^{-6}$ per $^\circ$C at operating temperatures, and two or more layers of aluminium to have rough surfaces free of contaminates, forming a laminate consisting of said alloy layer sandwiched between said aluminium layers, heat treating the laminate to cause aluminium to diffuse into the alloy layer and annealing the laminate.

2. A method as claimed in claim 1, in which the alloy layer is a layer of a nickel steel alloy having a thickness in the range of about 500 to 750 micrometers.

3. A method as claimed in claim 1 or claim 2, in which each of the aluminium layers of the laminate has a thickness in the range of about 125 to 250 micrometers.

4. A method as claimed in any preceding claim in which the laminate is formed by hot rolling an aluminium-alloy-aluminium sandwich.

5. A method as claimed in claim 4, in which the hot rolling step includes maintaining steel rollers at a temperature in the range of from about 315 to 473 $^\circ$C (600 to 900 $^\circ$F) in a reducing atmosphere.

6. A method as claimed in any preceding claim, in which the annealing step comprises subjecting the laminated structure to a temperature in the range of 260 $^\circ$C to 371 $^\circ$C (500 to 700 $^\circ$F) for one to five minutes.

7. A method as claimed in any preceding claim, including the additional step of forming at least one dielectric layer on the laminate by oxidizing at least one of the aluminium surfaces thereof.

8. A method as claimed in any of claims 1 to 7, including the additional step of applying an organic dielectric material to at least one of the aluminium surfaces of the laminate to form a dielectric layer thereon.

9. A method as claimed in claim 7 or claim 8, including the additional steps of applying a conductive pattern to the dielectric layer and attaching at least one electronic component device to the conductive pattern.

10. A method as claimed in claim 7 or claim 8, including the additional steps of laminating a layer of copper on the laminate;
   providing a dielectric polymer layer over the copper layer;
   selectively etching areas of the copper layer to form a conductive pattern; and
   attaching electronic components to the conductive pattern.

## Revendications

1. Méthode de formation d'un substrat pour circuits imprimés, comprenant les opérations successives de traitement de surface d'une couche d'un alliage ayant un coefficient de dilatation thermique inférieur à 6 x $10^{-6}$ par °C aux températures de fonctionnement, et de deux couches ou davantage d'aluminium afin d'obtenir des surfaces rugueuses exemptes de contaminants, formation d'un stratifié composé de ladite couche d'alliage interposée entre lesdites couches d'aluminium, traitement thermique du stratifié pour provoquer la diffusion de l'aluminium dans la couche d'alliage, et recuit du stratifié.

2. Méthode suivant la revendication 1, dans laquelle la couche d'alliage est une couche d'acier allié au nickel ayant une épaisseur comprise entre 500 et 750 $\mu$m environ.

3. Méthode suivant la revendication 1 ou la revendication 2, dans laquelle chacune des couches d'aluminium du stratifié a une épaisseur comprise entre 125 et 250 $\mu$m environ.

4. Méthode suivant l'une quelconque des revendications précédentes, dans laquelle le stratifié est formé par laminage à chaud d'une superposition d'aluminium-alliage-aluminium.

5. Méthode suivant la revendication 4, dans laquelle l'opération de laminage à chaud comprend le maintien de cylindres en acier à une température comprise entre 315 et 473 °C (600 à 900 °F) pendant 1 à 5 minutes.

6. Méthode suivant l'une quelconque des revendications précédentes, dans laquelle l'opération de recuit comprend l'exposition de la structure stratifiée à une température comprise entre 260 et 371 °C (500 à 700 °F) pendant 1 à 5 minutes.

7. Méthode suivant une quelconque des revendications précédentes, comprenant l'opération additionnelle de formation d'au moins une couche diélectrique sur le stratifié, par oxydation d'au moins une de ses surfaces d'aluminium.

8. Méthode suivant une quelconque des revendications 1 à 7, comprenant l'opération additionnelle d'application d'une matière diélectrique organique à au moins une des surfaces d'aluminium du stratifié pour former une couche diélectrique sur celui-ci.

9. Méthode suivant la revendication 7 ou la revendication 8, comprenant les opérations additionnelles d'application d'une configuration conductrice à la couche diélectrique et de fixation d'au moins un composant électronique à la configuration conductrice.

10. Méthode suivant la revendication 7 ou la revendication 8, comprenant les opérations additionnelles de

stratification d'une couche de cuivre sur le stratifié ;

formation d'une couche de polymère.diélectrique sur la couche de cuivre ;

attaque sélective de régions de la couche de cuivre pour former une configuration conductrice ; et

fixation de composants électroniques à la configuration conductrice.

## Ansprüche

1. Verfahren zum Ausbilden eines Substrates für gedruckte Schaltungen, welches nachstehende aufeinanderfolgende Schritte umfaßt:

Oberflächenbehandeln einer Schicht aus einer Legierung mit einem thermischen Ausdehnungskoeffizienten, der kleiner als $6.10^{-6}$ pro °C bei Betriebstemperaturen beträgt und zweier, oder mehrerer Schichten aus Aluminium, um rauhe, verunreinigungsfreie Oberflächen zu erhalten, Ausbilden eines Laminates, das aus zwischen den Aluminiumschichten geschichteten Verbindungsschichten besteht, Wärmebehandeln des Laminates, um zu bewirken, daß Aluminium in die Legierungschicht diffundiert und Tempern des Laminates.

2. Verfahren nach Anspruch 1, bei welchem die Legierungsschicht eine Schicht aus einer Nickel-Stahl-Legierung ist, die eine Dicke in dem Bereich von etwa 500 bis 750 Mikrometer aufweist.

3. Verfahren nach Anspruch 1 oder 2, bei welchem jede der Aluminiumschichten des Laminates eine Dicke in dem Bereich von etwa 125 bis 250 Mikrometer aufweist.

4. Verfahren nach irgendeinem der vorangehenden Ansprüche, bei welchem das Laminat durch Warmwalzen einer Aluminium-Legierung-Aluminium Sandwich-Anordnung gebildet wird.

5. Verfahren nach Anspruch 4, bei welchem der Schritt zum Warmwalzen das Halten von Stahlwalzen bei einer Temperatur in dem Bereich von 315 bis 473 °C (600 bis 900 °F) für eine bis fünf Minuten umfaßt.

6. Verfahren nach irgendeinem der vorgehenden Ansprüche, bei welchem der Schritt zum Tempern das Unterwerfen der geschichteten Anordnung einer Temperatur in dem Bereich von 260 bis 370 °C (500 bis 700 °F) für eine bis fünf Minuten umfaßt.

7. Verfahren nach irgendeinem der vorgehenden Ansprüche, welches den zusätzlichen Schritt zum Bilden zumindest einer dielektrischen Schicht auf dem Laminat durch Oxidieren zumindest einer der Aluminiumoberflächen darauf umfaßt.

8. Verfahren nach irgendeinem der Ansprüche 1 bis 7, welches den zusätzlichen Schritt zum Aufbringen eines organischen dielektrischen Materials auf zumindest eine der Aluminiumoberflächen des Laminates umfaßt, um darauf eine dielektrische Schicht auszubilden.

9. Verfahren nach Anspruch 7 oder 8, welches den zusätzlichen Schritt zum Aufbringen einer leitenden Struktur auf die dielektrische Schicht und zum Anbringen zumindest eines elektronischen Bauelementes an der leitenden Struktur umfaßt.

10. Verfahren nach Anspruch 7 oder 8, welches die folgenden zusätzlichen Schritte umfaßt:

Schichten einer Schicht aus Kupfer auf das Laminat,

Schaffen einer dielektrischen Polymerschicht über der Kupferschicht,

selektives Ätzen von Bereichen der Kupferschicht, um eine leitende Struktur auszubilden und

Anbringen elektronischer Bauelemente an der leitenden Struktur.

```
┌─────────────────────────┐
│ SURFACE                 │
│ PREPARATION             │
│ OF MATERIALS      10    │
└─────────────────────────┘
            │
┌─────────────────────────┐
│ FORM CLAD         20    │
│ MATERIAL                │
└─────────────────────────┘
            │
┌─────────────────────────┐
│ ANNEAL AND              │
│ QUENCH            30    │
└─────────────────────────┘
```

# FIG. 1

**FIG. 2**

```
┌─────────────────────────┐
│ OXIDIZE           60    │
└─────────────────────────┘
            │
┌─────────────────────────┐
│ APPLY             64    │
│ CONDUCTORS              │
└─────────────────────────┘
            │
┌─────────────────────────┐
│ APPLY             68    │
│ SOLDER                  │
└─────────────────────────┘
            │
┌─────────────────────────┐
│ MOUNT             72    │
│ COMPONENTS              │
└─────────────────────────┘
```

# FIG. 3

```
┌─────────────────────────┐
│ SURFACE PREP      80    │
└─────────────────────────┘
            │
┌─────────────────────────┐
│ COPPER LAMINATE   84    │
└─────────────────────────┘
            │
┌─────────────────────────┐
│ APPLY POLYMER     88    │
└─────────────────────────┘
            │
┌─────────────────────────┐
│ ETCH              92    │
└─────────────────────────┘
            │
┌─────────────────────────┐
│ APPLY SOLDER      96    │
└─────────────────────────┘
```

# FIG. 4